# EUROPÄISCHE PATENTSCHRIFT

(11) **EP 2 293 883 B1**
(45) Veröffentlichungstag und Bekanntmachung des Hinweises auf die Patenterteilung: **21.03.2018**
(21) Anmeldenummer: 09757537.7
(22) Anmeldetag: 03.06.2009
(51) Int. Cl.: B05D 7/24

(54) **VERFAHREN UND VORRICHTUNG ZUM ABSCHEIDEN DÜNNER SCHICHTEN AUS POLYMEREN PARA-XYLYLENE ODER SUBSTITUIERTEM PARA-XYLYLENE**
METHOD AND APPARATUS FOR DEPOSITING THIN LAYERS OF POLYMERIC PARA-XYLYLENE OR SUBSTITUTED PARA-XYLYLENE
PROCÉDÉ ET DISPOSITIF DE DÉPÔT DE COUCHES MINCES DE PARA-XYLYLÈNES POLYMÈRES OU DE PARA-XYLYLÈNE SUBSTITUÉ

(30) Priorität: 03.06.2008 DE 102008026974
(43) Veröffentlichungstag der Anmeldung: 16.03.2011
(73) Patentinhaber: Aixtron SE, 52134 Herzogenrath (DE)
(72) Erfinder: GERSDORFF, Markus, 52134 Herzogenrath (DE); GOPI, Baskar, Pagadala, 52072 Aachen (DE); MEYER, Nico, 52062 Aachen (DE)
(74) Vertreter: Grundmann, Dirk
(86) Internationale Anmeldenummer: PCT/EP2009/056768
(87) Internationale Veröffentlichungsnummer: WO 2009/147156

(56) Entgegenhaltungen:
- US-A1- 2005 000 434
- US-B1- 6 709 715

## Beschreibung

Die Erfindung betrifft eine Vorrichtung zum Abscheiden einer oder mehrerer dünner Schichten aus polymeren Para-Xylylene oder substituiertem Para-Xylylene mit einem beheizten Verdampfer zum Verdampfen eines festen oder flüssigen Ausgangsstoffs, insbesondere in Form einen Polymers, insbesondere eines Dimers, in welchem Verdampfer eine Trägergaszuleitung für ein Trägergas mündet, mit welchem Trägergas der verdampfte Ausgangsstoff insbesondere das verdampfte Polymer, insbesondere Dimer in eine dem Verdampfer nachgeordnete, beheizbare Zerlegungskammer, insbesondere Pyrolysekammer transportiert wird, in welcher der Ausgangsstoff, insbesondere in ein Monomer zerlegt wird, und mit einer der Zerlegungskammer nachgeordneten Depositionskammer, welche einen Gaseinlass, durch welchen das vom Trägergas transportierte Zerlegungsprodukt, insbesondere Monomer eintritt, einen Suszeptor, welcher eine dem Gaseinlass gegenüberliegende kühlbare Tragfläche aufweist zur Auflage eines mit dem polymerisierten Zerlegungsprodukt, insbesondere Monomer zu beschichtenden Substrates, und einen Gasauslass, durch welchen das Trägergas und ein nicht polymerisierter Teil des Zerlegungsproduktes, insbesondere Monomers austritt, aufweist, wobei der Gaseinlass einen Gasflächenverteiler ausbildet, der eine sich parallel zur Tragfläche erstreckende, beheizbare Gasaustrittsfläche aufweist, mit einer Vielzahl von über die gesamte Gasaustrittsfläche verteilt angeordneten Gasaustrittsöffnungen.

Die Erfindung betrifft darüber hinaus ein Verfahren zum Abscheiden ein oder mehrerer dünner Schichten aus polymerem Material, insbesondere Para-Xylylene, oder substituiertem Para-Xylylene wobei ein fester oder flüssiger insbesondere von einem Polymer, insbesondere Dimer gebildeter Ausgangsstoff in einem Verdampfer verdampft wird, der Ausgangsstoff, insbesondere das Dimer mittels eines Trägergases vom Verdampfer durch eine Trägergaszuleitung in eine Zerlegungskammer, insbesondere Pyrolysekammer transportiert wird, in der Zerlegungskammer bevorzugt pyrolytisch, insbesondere in ein Monomer zerlegt wird, das Zerlegungsprodukt, insbesondere Monomer vom Trägergas aus der Zerlegungskammer in eine Depositionskammer transportiert wird, in welcher ein Substrat auf einer Tragfläche eines Suszeptors aufliegt, dort durch einen Gaseinlass in die Depositionskammer einströmt, wobei das Zerlegungsprodukt, insbesondere Monomer, zusammen mit dem Trägergas aus Gasaustrittsöffnungen einer sich parallel zur Tragfläche erstreckenden Gasaustrittsfläche eines vom Gaseinlass ausgebildeten Gasflächenverteilers in Richtung senkrecht auf die Substratoberfläche austritt und auf der Oberfläche des Substrates als dünne Schicht polymerisiert, und wobei das Trägergas und ein nicht polymerisierter Teil des Zerlegungsproduktes, insbesondere Monomers aus einem Gasauslass aus der Prozesskammer austritt, wobei die Tragfläche derart gekühlt und die der Tragfläche gegenüberliegende Gasaustrittsfläche derart beheizt wird, dass die Oberflächentemperatur der Gasaustrittsfläche höher ist, als die Oberflächentemperatur der Tragfläche.

Aus den US 6,709,715 B1, US 6,362,115 B1 und US 5,958,510 A ist eine Vorrichtung zum Abscheiden von P-Xylylenen bekannt, bei der der Ausgangsstoff über ein Trägergas einer Zerlegungskammer zugeführt wird, dort zerlegt wird, die Zerlegungsprodukte zum Gaseinlass einer Prozesskammer gebracht werden, durch den Gaseinlass in die Prozesskammer eingeleitet werden und auf einem gekühlten Substrat polymerisieren. Das Gaseinlass-System besitzt eine mit einer Vielzahl von Öffnungen versehene Platte, die sich parallel zum Substrat über dessen gesamte Fläche erstreckt.

Die US 4,945,856 beschreibt ein Verfahren, bei dem in einem Gasgenerator ein fester Ausgangsstoff, bei dem es sich um ein dimeres Para-Xylylen handelt, in eine Gasform gebracht wird. Dieses Gas wird über Gasleitungen in eine Pyrolysekammer geleitet. Dort wird das Dimer in ein Monomer zerlegt. Das Monomer wird über eine Gasleitung vom Trägergas in eine Prozesskammer geleitet. Dort tritt es durch einen von einer Rohröffnung gebildeten Gaseinlass ein, um dort auf einem auf einer Auflagefläche eines Suszeptors aufliegenden Substrat zu kondensieren. Die Prozesskammer besitzt darüber hinaus einen Gasauslass, aus dem das nicht auf der Substratoberfläche polymerisierte Monomer austreten kann. In einer dem Gasauslass nachgeordneten Kühlfalle wird das Monomer aus dem Trägergas ausgefroren. Der Druck in der Prozesskammer wird mittels einer Vakuumpumpe eingestellt, die der Kühlfalle nachgeordnet ist.

Die verwendeten Para-Xylylene-Copolymere werden von der US 3,288,728 beschrieben. Es handelt sich dabei um C-, N-, D-Polymere der Parylene-Familie, die bei Raumtemperatur im festen pulverförmigen oder in flüssiger Phase vorliegen.

Aus "Characterization of Parylene Deposition Process for the Passivation of Organic Light Emmiting Diodes", Korean J. Chem. Eng., 19(4), 722-727 (2002) ist es bekannt, OLEDs mit Schichten von Poly-P-Xylylene und dessen Derivate zu passivieren, insbesondere zu kapseln. Ansonsten ist es bekannt, verschiedenartige großflächige Substrate mit einer Parylene-Beschichtung im Vakuum zu versehen. So werden beispielsweise Glas, Metall, Papier, Lack, Kunststoff, Keramik, Ferrit und Silikon durch Kondensation aus der Gasphase mit einem porenfreien und transparenten Polymerfilm beschichtet. Dabei macht man sich die hydrophobe, chemisch resistente und elektrisch isolierende Eigenschaft der polymeren Beschichtung zunutze.

Der Erfindung liegt die Aufgabe zugrunde, Maßnahmen vorzuschlagen, mit denen eine großflächige, dünne und insbesondere hinsichtlich der Schichtdicke homogene Polymerschicht abgeschieden werden kann.

Gelöst wird die Aufgabe durch die in den Ansprüchen angegebene Erfindung, wobei jeder Anspruch eine eigenständige Lösung der Aufgabe darstellt und mit jedem anderen Anspruch kombinierbar ist.

Zunächst und im Wesentlichen wird ein Gasflächenverteiler als Gaseinlass vorgeschlagen. Mit dem Gasflächenverteiler ist eine gleichmäßige Versorgung der Gasphase oberhalb des Substrates mit Depositionsmaterial möglich. Es können Schichten mit Schichtdicken im Submikronbereich abgeschieden werden, die über die gesamte Substratoberfläche, die größer als ein halber Quadratmeter sein kann, homogen ist. Hierdurch ist die Anwendung des Verfahrens in der Halbleitertechnologie geeignet. Mit der erfindungsgemäßen Vorrichtung und dem erfindungsgemäßen Verfahren ist die Abscheidung di-elektrischer Schichten bei der Herstellung von Feldeffekttransistoren als Gate-Isolierschicht möglich. So werden insbesondere 200 nm dicke Gateisolierungen auf großflächige, vorstrukturierte Substrate abgeschieden. Die Abscheidung der di-elektrischen Isolationsschichten kann strukturiert erfolgen. Hierzu kann auf das Substrat eine Schattenmaske aufgelegt werden. Das erfindungsgemäße Verfahren bzw. die erfindungsgemäße Vorrichtung lässt sich für jede Art der großflächigen Beschichtung einsetzen. Insbesondere ist die Verwendung zur Fertigung von E-Paper vorgesehen. Dabei wird ein flexibles großschichtiges, insbesondere goldstrukturiertes Substrat mit dem Polymer beschichtet. Auch bei der TFT-Technik kann das Verfahren bzw. die Vorrichtung verwendet werden. Der erfindungsgemäß verwendete Gasflächenverteiler besitzt eine Gasaustrittsfläche, die eine siebartige Struktur aufweist. Sie besitzt eine Vielzahl von im Wesentlichen gleichmäßig über die Gasaustrittsfläche verteilte Gasaustrittsöffnungen, durch die düsenartig jeweils ein dünner Gasstrahl in Richtung auf das Substrat austritt. Die Größe der Gasaustrittsfläche entspricht im Wesentlichen der Größe des davon beabstandet angeordneten Substrates. Gasaustrittsfläche und Tragfläche des Suszeptors, auf welchem das Substrat oder die Substrate aufliegt, verlaufen parallel zueinander und bevorzugt in der Horizontalebene. Der Abstand zwischen Gasaustrittsfläche und der Auflagefläche des Suszeptors, auf welchen das Substrat aufliegt, ist so gewählt, dass dort eine im Wesentlichen einheitliche Gasfront des aus den Gasaustrittsöffnungen heraustretenden Gases ankommt. Die Gasaustrittsöffnungen sind entsprechend dicht benachbart. Die einzelnen dort austretenden "Gasstrahlen" verbinden sich zu der erwähnten einheitlichen Gasfront. Die Prozesstemperatur des Suszeptors ist niedriger als die Prozesstemperatur des Gasflächenverteilers. Die Temperatur des Gasflächenverteilers liegt im Bereich zwischen 150°C und 250°C. Die Temperatur des Suszeptors im Bereich von -30°C bis 100°C. Zur Vermeidung von Energieübertragung im Wege der Wärmestrahlung vom Gasflächenverteiler zum Suszeptor besitzt der Gasflächenverteiler und insbesondere die auf den Suszeptor gerichtete Gasaustrittsfläche ein sehr geringes Emissionsvermögen. Die Emissivität liegt im Bereich ε < 0,04. Dies wird durch Polieren oder Vergolden der Oberfläche des Gasflächenverteilers und insbesondere der Gasaustrittsfläche erreicht. Der hochglanzpolierte Gasflächenverteiler wirkt mit einer minimierten Strahlungsleistung auf die zu beschichtende Oberfläche des Substrates. Da die Oberflächentemperatur der Gausaustrittsfläche deutlich höher ist als die Oberflächentemperatur der Tragfläche bildet sich innerhalb der Gasphase der Depositionskammer, die sich zwischen Gasaustrittsfläche und Tragfläche erstreckt, ein vertikaler Temperaturgradient. Das Substrat liegt flächig auf der Tragfläche auf und steht somit in einer Temperaturleitverbindung mit dem Suszeptor. Trotz der minimierten Strahlungsleistung der beschichteten beheizten Oberfläche des Gaseinlasses kann sich die Oberfläche des Substrates aufwärmen. Die Wärme fließt jedoch über die Wärmeleitverbindung zwischen Unterseite des Substrates und Tragfläche in den Suszeptor ab. Letzterer wird bevorzugt gekühlt. Der Gasflächenverteiler kann aus Aluminium oder Edelstahl bestehen. Der aus einem Trägergas und dem Monomer bestehende, aus den Gasaustrittsöffnungen düsenartig austretende Gasstrom gelangt als Gasfront zur Substratoberfläche. An der Oberfläche wird das Monomer adsorbiert. Das adsorbierte Monomer wächst dort in einem Polymerisationswachstumsprozess zu einer Schicht. Über den vom Gasflächenverteiler mitbeeinflussten Temperaturgradient lässt sich die Wachstumsrate beeinflusse bzw. kontrollieren. Durch diesen Temperaturgradient wird eine hohe Wachstumseffizienz ermöglicht. Der Gebrauch des Gasflächenverteilers ermöglicht eine großflächige Beschichtung beginnend im Bereich von 150 mm x 150 mm bis hin zu 1000 mm x 1000 mm. Substrate dieser Größe können gleichmäßig mit dem Polymermaterial beschichtet werden. Die nicht zum Filmwachstum beitragenden Moleküle werden aus der Monomergasphase über einen geheizten Gasabfluss aus der Prozesskammer geleitet. Eine Vakuumpumpe fördert das Abgas durch einen beheizten Gasabfluss zwischen 50°C und 250°C in eine Kühlfalle, wo das Monomer ausfriert. Die Prozessdrucke liegen bei 0,05 mbar bis 0,5 mbar. Der Druckverlust über den Gasflächenverteiler ist kleiner als 0,5 mbar. Dies ermöglicht einen Zerlegungsdruck (Pyrolysedruck) von weniger als 1 mbar. Um den Substrathalter auf die gewünschte lateral homogene Oberflächentemperatur zu bringen, besitzt er eine Temperiereinrichtung, die von Temperierflüssigkeitskanälen ausgebildet sein kann. die Kanäle werden von einer Flüssigkeit durchströmt, die im Temperaturbereich zwischen -30°C und 100°C flüssig ist. Bevorzugt sind zwei gegenläufig durchströmte, parallel zueinander verlaufende Temperierflüssigkeitskanäle vorgesehen.

Auch der Gasflächenverteiler besitzt Temperiermittel. Auch hier kann es sich um Kanäle handeln, durch die eine temperierte Flüssigkeit strömt. Bevorzugt sind die Kanäle in einer die Gasaustrittsfläche ausbildenden Platte des Gasflächenverteilers angeordnet. Die Kanäle, die in der Gasaustrittsfläche münden, können von kleinen Röhrchen gebildet sein. Im Zwischenraum zwischen den Röhrchen können die erwähnten Kanäle verlaufen. Anstelle der mit einer Heizflüssigkeit durchströmten Kanäle können dort aber auch Heizwendel oder Heizdrähte liegen, die elektrisch beheizt werden. Bevorzugt wird eine derartige Widerstandsbeheizung der Gasaustrittsfläche. Rückwärtig der Platte befindet sich ein Gasvolumen, welches durch einen Eingangsverteiler gespeist wird. In diesen mündet eine beheizte Gaszuleitung, durch die das Trägergas mit dem Polymer in den Gaseinlass transportiert wird. Die Wände der Prozesskammer sind ebenfalls beheizt. Sie werden auf Temperaturen im Bereich zwischen 150°C und 250°C gehalten. Der Abstand zwischen der Gasaustrittsfläche und der Substratoberfläche bzw. der Tragfläche liegt im Bereich zwischen 10 mm und 50 mm und kann gegebenenfalls eingestellt werden.

Als Substrate kommen Display-Substrate, Siliziumwafer, Plastiksubstrate oder Papiersubstrate in Betracht. Auf die Substrate wird in der zuvor beschriebenen Vorrichtung bzw. mit dem erfindungsgemäßen Verfahren eine di-elektrische Schicht abgeschieden. Bei dem Substrat kann es sich um ein di-elektrisches Substrat oder ein nicht di-elektrisches Substrat aber auch um ein Metall oder einen Halbleiter handeln. Das Substrat ist bevorzugt vorstrukturiert, beispielsweise können dort Halbleiterschaltungen und insbesondere Transistoren aufgebracht worden sein. Die Unterseite des Substrats liegt in Flächenanlage auf der Tragfläche des Suszeptors, welcher von einem Kühlblock gebildet werden kann, der aus Aluminium oder aus Kupfer besteht. Der Suszeptor kann statisch fest in der Prozesskammer angeordnet sein. Es ist aber auch vorgesehen, dass er um eine zentrale, insbesondere vertikale Achse rotieren kann. Bei dem erfindungsgemäßen Verfahren wird ein Trägergas, welches Argon, Stickstoff oder Helium sein kann, von einem Massenflusskontroller bereit gestellt und über eine Zuleitung, die mittels eines Ventils verschließbar ist, einem Verdampfer zugeleitet. Im Verdampfer befindet sich ein flüssiger oder fester Ausgangsstoff, bei dem es sich um ein Parylen-Dimer handelt. Bei einer Temperatur zwischen 50°C und 200°C wird das Dimer verdampft und mittels des Trägergases durch eine mittels Ventil verschließbare und beheizte Gasleitung einem Pyrolyseofen zugeleitet. Die dortige Temperatur beträgt bei einem Druck von < 1 mbar 350°C bis 700°C. Das Dimer zerlegt sich dort pyrolytisch in ein Monomer, welches über eine ebenfalls beheizte Gasleitung in einen Eingangsverteiler einer Prozesskammer transportiert wird. Das Trägergas und das von ihm getragene Monomer treten dann in die rückwärtig der Platte die Austrittsöffnungen aufweisenden Kammer des Gasflächenverteilers. Mit einem geringen Druckverlust durchströmt dieses Prozessgas die gleichmäßig über die Gasaustrittsfläche verteilten Gasaustrittsöffnungen und gelangt als Gasfront zur Oberfläche des Substrates. Dort adsorbieren die Monomere und polymerisieren zu einer di-elektrischen Schicht bei Wachstumsraten von bis zu 2 µm/s. Die Verweilzeit der Dimere im Pyrolyseofen und der Druckgradient dort wird über den Massenflusskontroller bzw. über den Druck in der Prozesskammer eingestellt. Die sich parallel zum Gasflächenverteiler erstreckende Beschichtungsfläche beträgt bevorzugt mehr als ein halber Quadratmeter. Die Verbindungsleitungen von der von dem Verdampfer ausgebildeten Quelle bis hin zur Kammer bzw. zur Kühlfalle sind auf eine Temperatur beheizt, die oberhalb der Polymerisationstemperatur liegt. Letzteres gilt auch für den aktiv beheizten Gasverteiler. Dieser ist auf Hochglanz poliert oder vergoldet. Die flächige Einleitung des Prozessgases über im Wesentlichen die gesamte Fläche, die vom Substrat eingenommen wird, in Verbindung mit den übrigen konstruktiven und verfahrenstechnischen Merkmalen erreicht eine hohe Effizienz. Nur ein Minimum des in die Prozesskammer eingeleiteten Monomers polymerisiert nicht auf dem Substrat und verschwindet als Ausschuss in der Kühlfalle.

Die erfindungsgemäße Vorrichtung bzw. das erfindungsgemäße Verfahren dient insbesondere dem Abscheiden polymeren Para-Xylylene oder substituiertem Para-Xylylene. Beispielsweise kann es sich um Parylene C handeln. Der Transport des verdampften Materials erfolgt mit einem Trägergas, bei welchem es sich beispielsweise um N2 oder Argon oder ein anderes geeignetes inertes Gas handelt. Die Zerlegung des Ausgangsmaterials erfolgt lediglich vorzugsweise pyrolytisch. Es ist auch vorgesehen, das Ausgangsmaterial anderweitig, beispielsweise unterstützt durch ein Plasma zu zerlegen. Bei dem zu zerlegenden Ausgangsmaterial muss es sich nicht notwendigerweise um ein Dimer handeln. Der Ausgangsstoff kann darüber hinaus auch kaskadenartig in ein Monomer oder in weitere Zerlegungsprodukte zerlegt werden. Von besonderer Bedeutung ist ferner die Polymerkettenbildung auf dem Beschichtungsobjekt.

Ein Ausführungsbeispiel der Erfindung wird nachfolgend anhand beigefügter Zeichnungen erläutert. Es zeigen:

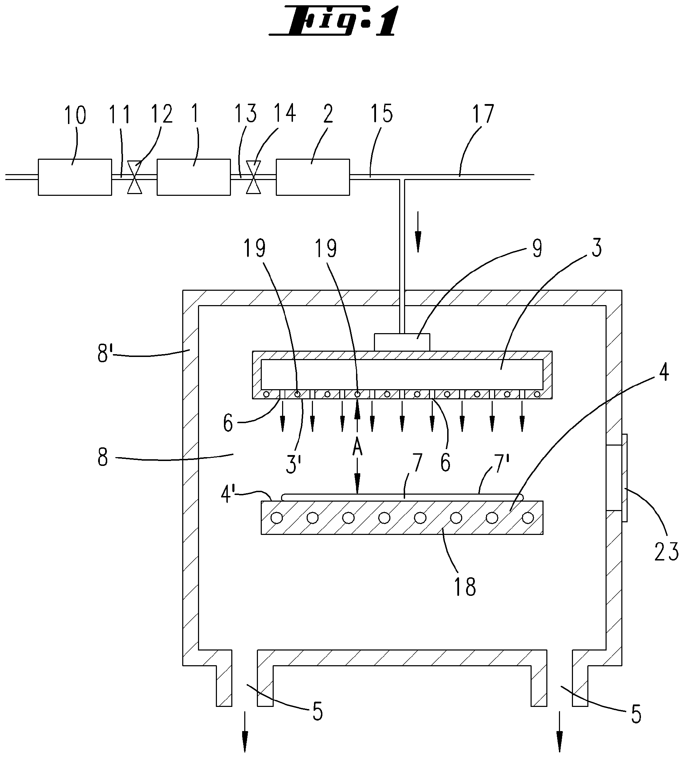

- Fig. 1: schematisch die wesentlichen Bestandteile der Beschichtungsvorrichtung und insbesondere den inneren Aufbau der Prozesskammer,
- Fig. 2: die Draufsicht auf eine Gasaustrittsfläche und
- Fig. 3: die Draufsicht auf die Tragfläche eines Suszeptors mit darauf liegendem Substrat,
- Fig. 4: eine schematische Darstellung eines weiteren Ausführungsbeispiels,
- Fig. 5: einen Schnitt gemäß der Linie V-V in Figur 4,
- Fig. 6: eine perspektivische Darstellung eines Teils einer Innenplatte der unteren Wandung des Gaseinlasses 3, auf dem Kopf stehend,

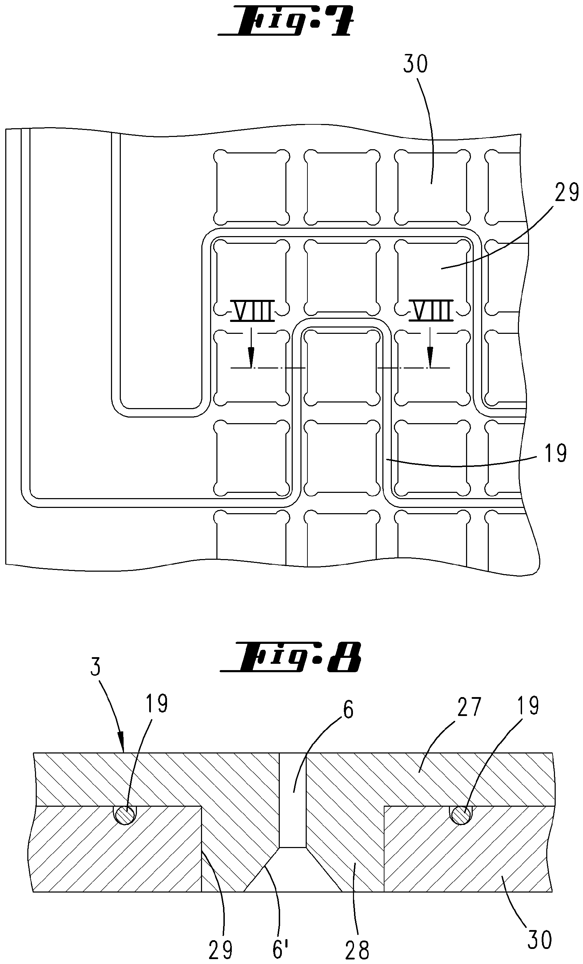

- Fig. 7: eine Teildarstellung einer Außenwand 30 des Gaseinlasses, ebenfalls auf dem Kopf stehend und
- Fig. 8: einen Schnitt durch die untere Wandung des Gaseinlasses im Bereich einer Gasaustrittsöffnung.

Mit einem Massenflusskontroller 10 wird der Massenfluss eines Trägergases, welches aus Helium, Argon oder Stickstoff bestehen kann, eingestellt. Das Trägergas fließt durch eine Gasleitung 11, die mit einem Ventil 12 verschließbar ist, in einen Verdampfer 1.

Der Verdampfer 1 besitzt Schalen oder anderweitig gestaltete Behälter, die einen flüssigen oder festen Ausgangsstoff bevorraten, bei dem es sich um einen Stoff der Parylene-Familie, insbesondere C-, N-, D-Polymer-Para-Xylylene handelt. Das Pulver bzw. die Flüssigkeit wird mit einer nicht dargestellten Heizung auf eine Quellentemperatur von 50°C bis 200°C beheizt. Das Volumen des Quellenbehälters ist im Verhältnis zum Massenstrom des den Verdampfer durchströmenden Trägergases so ausgelegt, dass die Gasphase und die Festkörper bzw. Flüssigkeitsphase im Wesentlichen im thermischen Gleichgewicht liegen. Mittels des Trägergasstromes wird der verdampfte Ausgangsstoff, bei dem es sich bevorzugt um ein Dimer handelt, durch eine beheizte Gasleitung 13, die ebenfalls mit einem Ventil 14 verschließbar ist, in eine Pyrolysekammer 2 geleitet.

Die Pyrolysekammer 2 ist mit einer nicht dargestellten Heizung auf Temperaturen im Bereich zwischen 350°C bis 700°C aufheizbar. Bei einem dortigen Totaldruck von weniger als 1 mbar wird das Dimer in ein Monomer pyrolytisch zerlegt.

Über eine ebenfalls beheizte Gasleitung 15, in die noch eine zusätzliche Gasleitung 17 mündet, wird das Monomer zusammen mit dem Trägergas in die Prozesskammer eingeleitet. Durch die zusätzliche Zuleitung 17 ist es möglich, zusätzliches Material in die Prozesskammer einzuleiten. Über die Zuleitung 17, die ebenfalls beheizt ist, können die gleichen Materialien oder andere Materialien zu dem Ausgangsstoff beigemischt werden.

Die Beheizung der zuvor erwähnten Gasleitungen 11,13,15 und 17 kann über Heizmanschetten erfolgen. Diese können mittels Heizwendeln aufgeheizt werden. Es ist aber auch möglich, die Leitungen zusammen mit der Verdampfungskammer 1 und der Pyrolysekammer 2 in einem beheizten Gehäuse anzuordnen. Dieses kann räumlich oberhalb oder neben der eigentlichen Prozesskammer angeordnet sein.

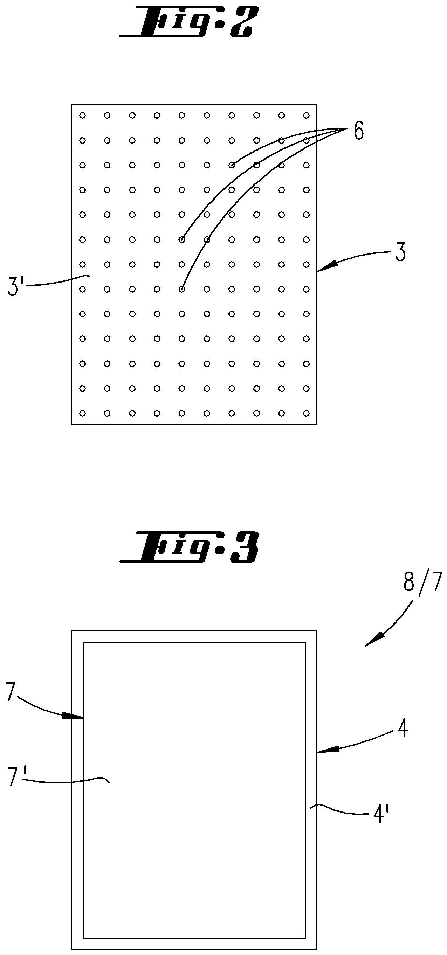

Innerhalb der Prozesskammer 8, deren Wände 8' beheizt werden können, befindet sich im oberen Bereich ein Gaseinlass 3. Dieser besitzt einen Eingangsverteiler 9, in den die Gasleitung 15 mündet. Der wesentliche Bestandteil des Gaseinlasses 3 ist ein Gasflächenverteiler, der eine zentrale Kammer ausbildet, in die das Gas vom Eingangsverteiler 9 eintritt. Der Boden der Kammer des Gasflächenverteilers 3 kann eine rechteckige oder kreisförmig Gestaltung besitzen. Im Ausführungsbeispiel (Figur 2) besitzt der Boden der Kammer 3 eine rechteckige Gestalt mit Kantenlängen von 700 und 800 mm. Die den Boden der Gasverteilkammer ausbildenden Platte besitzt eine Vielzahl von Kanälen 19, durch welche Temperierflüssigkeit strömt, um die Platte auf einer Temperatur im Bereich zwischen 150°C und 250°C zu halten. Anstelle der Kanäle 19 können aber auch Heizwendeln oder dergleichen vorgesehen sein. Wesentlich ist eine Vielzahl von in gleichmäßiger Flächenverteilung angeordneter Gasaustrittsöffnungen 6. Durch diese dünnen, kapillarartigen Gasaustrittsöffnungen 6 tritt das Trägergas und das von ihm getragene Monomer in Form von "Gasstrahlen" in die Prozesskammer 8. Dies erfolgt bei einer Druckdifferenz von weniger als 0,5 mbar.

Die Außenfläche des Gasflächenverteilers 3 bildet eine Gasaustrittsfläche 3' aus, die sich in Horizontalrichtung erstreckt.

Parallel zur Gasaustrittsfläche erstreckt sich eine Tragfläche 4' eines Suszeptors 4. Die Tragfläche 4' ist mit einem Abstand A, der etwa 10 mm bis 50 mm beträgt, von der Gasaustrittsfläche 3' beabstandet. Die in der Figur 3 dargestellte von der Oberseite eines Suszeptors 4 ausgebildete Tragfläche 4' besitzt etwa dieselbe Größe wie die Gasaustrittsfläche 3', wobei letztere sogar etwas größer sein kann.

Der Suszeptor 4 wird von einem Kühlblock gebildet. Letzterer besteht aus Aluminium oder aus Kupfer und besitzt eine Vielzahl von Temperiermittelkanäle 18, durch die eine Flüssigkeit fließen kann. Es können zwei mäanderförmig angeordnete, parallel zueinander verlaufende und in Gegenrichtung durchströmte Kanäle vorgesehen sein. Damit wird der Suszeptor 4 und insbesondere seine als Auflagefläche für das Substrat 7 dienende Oberfläche 4' aktiv gekühlt.

Auf der Tragfläche 4' liegt in flächiger Oberflächenanlage ein Substrat 7. Es kann sich dabei um ein di-elektrisches aber auch um ein nicht di-elektrisches Substrat handeln, beispielsweise einem Display, einem Siliziumwafer oder Papier. Das Substrat 7 liegt in flächiger Auflage auf der Tragfläche 4', so dass ein Wärmetransport vom Substrat 7 auf den Suszeptor 4 möglich ist.

Im Bereich des Bodens der Prozesskammer 8 befinden sich zwei Gasauslassöffnungen 5, die mit einer beheizten, nicht dargestellten Leitung mit einer nicht dargestellten Kühlfalle verbunden sind. Die beispielsweise auf der Temperatur von flüssigem Stickstoff gehaltene Kühlfalle friert im Abgas befindliches Parylene aus. Stromabwärts der Kühlfalle befindet sich eine nicht dargestellte Vakuumpumpe, die druckgeregelt ist und mit der der Binnendruck innerhalb der Prozesskammer 8 eingestellt werden kann.

Der Prozessdruck in der Prozesskammer 8 wird in einem Bereich von 0,05 mbar bis 0,5 mbar eingestellt. Die Temperatur des Suszeptors liegt deutlich unterhalb der Temperatur der Prozesskammerwände 8' bzw. der Temperatur des Gasflächenverteilers 3, die im Bereich zwischen 150°C und 250°C liegt. Um ein Aufheizen des Substrates durch Wärmestrahlung vom Gasflächenverteiler 3 zu minimieren ist letzterer hochglanzpoliert und/oder vergoldet. Sein Emissionsvermögen ε liegt dabei unter 0,04.

Das aus den duschkopfartig angeordneten Gasaustrittsöffnungen 6 austretende Gas trifft als Gasfront auf die Oberfläche 7' des Substrates 7, wo die Monomere adsorbieren. Das adsorbierte Material polymerisiert dort zu einem Film bei Wachstumsraten von bis zu 2 µm/s. Die laterale Homogenität der Oberflächentemperatur der Tragfläche 4' liegt bei ± 0,5°C.

Mit der Bezugsziffer 16 ist eine Ent- und Beladeöffnung dargestellt, die Vakuumdicht verschließbar ist und die in der Seitenwand der Prozesskammer vorgesehen ist, um das Substrat 7 zu handhaben.

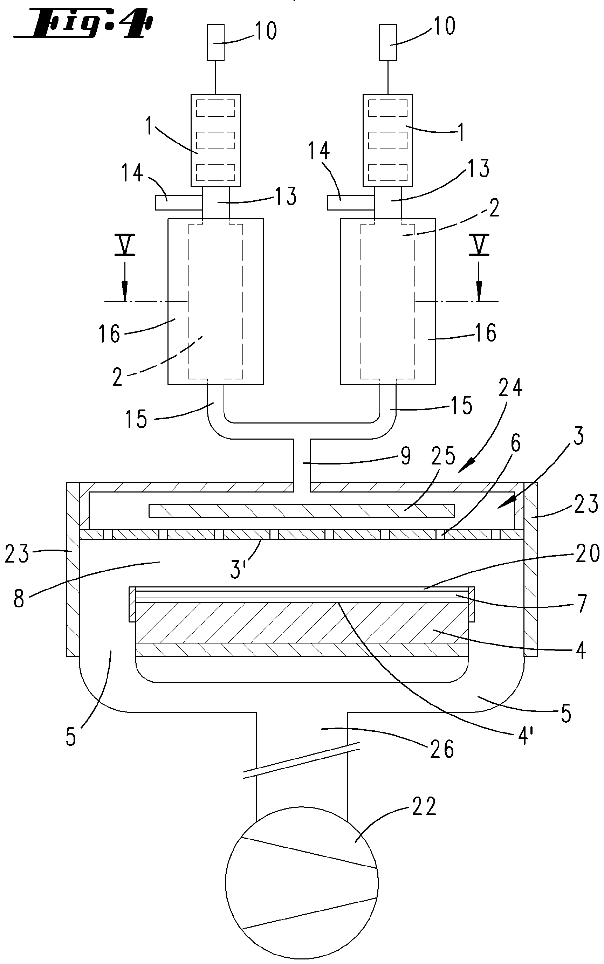

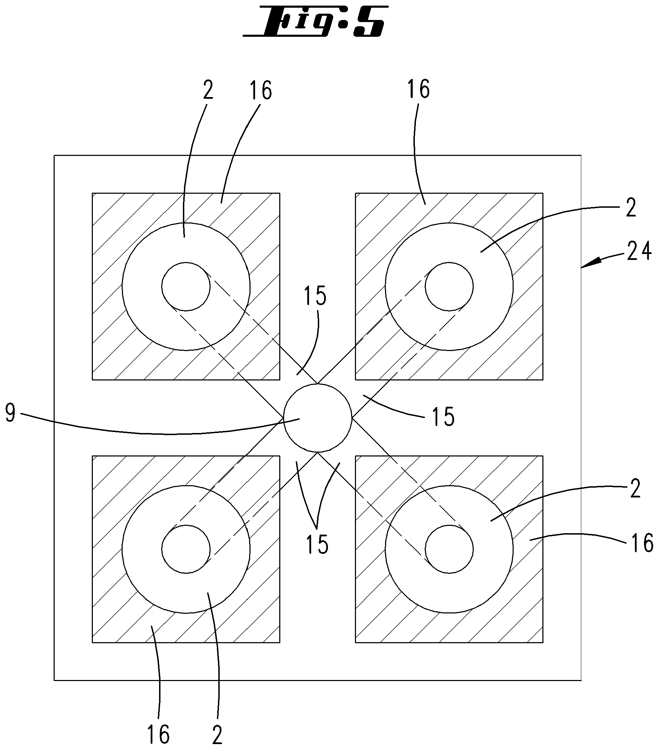

Bei den in den Figuren 4 und 5 dargestellten Ausführungsbeispielen wird der Gaseinlass 3 von insgesamt vier Pyrolysekammern 2 mit jeweils vorgeordneten Verdampfern 1 gespeist. Die auch mit Prozesskammer bezeichenbare Depositionskammer 8 befindet sich in einem etwa quaderförmigen Reaktorgehäuse 24. Unterhalb der rechteckigen Deckenfläche des Reaktorgehäuses 24 befindet sich ein nahezu die gesamte Innenseite der Deckenfläche in Anspruch nehmender Gaseinlass 3 mit einer Verteilkammer, in die ein Eingangsverteiler 9 in Form eines durchmessergroßen Rohres mündet. Vor der Mündung des Rohres 9 erstreckt sich eine Platte 25, mit der das in die Kammer des Gaseinlasses 3 einmündende Prozessgas verteilt wird. Parallel zur Deckelplatte des Reaktorgehäuses 24 befindet sich eine Lochplatte mit Öffnungen 6, die eine Gasaustrittsfläche 3' ausbildet, die sich parallel zur Deckelplatte des Reaktorgehäuses 24 erstreckt. Die Vielzahl der Öffnungen 6 ist gleichmäßig über die Gasaustrittsfläche 3' verteilt.

In der die Gasaustrittsfläche 3' ausbildenden Platte, die mehrschichtig aufgebaut sein kann, befinden sich nicht dargestellte Temperiermittel. Bei den Temperiermitteln handelt es sich um Heizdrähte, die elektrisch beheizt werden. Anstelle einer derartigen Widerstandsheizung kann die die Gasaustrittsfläche 3' ausbildende Platte aber auch Kanäle aufweisen, durch die eine temperierte Flüssigkeit strömt.

Werden als Temperiermittel Heizdrähte verwendet, so ist die mehrschichtig aufgebaut. Zwei voneinander entfernte Platten, von denen die eine die untere Wandung des Gasvolumens und die andere Platte die Gasaustrittsfläche 3' ausbildet, sind mittels Röhrchen miteinander verbunden, wobei die Röhrchen die Öffnungen 6 ausbilden. Im Zwischenraum zwischen den Röhrchen verlaufen die besagten Heizdrähte.

Etwa in einem Abstand von 25 mm bis 50 mm befindet sich unterhalb der Gasaustrittsfläche 3' ein Suszeptor 4. Auf der zur Gasaustrittsfläche 3' hinweisenden Tragfläche 4' des Suszeptors 4 liegt ein Substrat 7 auf. Es sind nicht dargestellte Positioniermittel vorgesehen, um das vorstrukturierte Substrat 7 exakt auf der Tragfläche 4' zu positionieren. Oberhalb des Substrates 7 befindet sich eine Schattenmaske 20, die mit geeigneten Maskenhalterungen exakt zum Substrat 7 positioniert ist. Der Suszeptor 4 ist mit nicht dargestelltem Temperiermittel auf einer Temperatur temperierbar, die deutlich niedriger ist, als die Temperatur des Gaseinlasses 3. Die Temperatur der Gasaustrittsfläche 3' ist mindestens 50°C und bevorzugt mindestens 100°C höher als die Temperatur der Tragfläche 4'. Auf der Tragfläche 4' liegt das Substrat 7 derart auf, dass Wärme, die als Strahlungswärme vom Gaseinlass 3 auf das Substrat 7 übertragen wird, an den Suszeptor 4 abgeleitet werden kann. Hierdurch ist sichergestellt, dass die Oberflächentemperatur des Substrates 7 nur geringfügig höher ist als die Oberflächentemperatur der Tragfläche 4'.

Die Gasauslassöffnungen werden von Rohren mit großem Durchmesser gebildet. Diese Rohre münden in ein Rohr 26, welches ebenfalls einen großen Durchmesser aufweist, und welches mit einer Pumpe 22 verbunden ist.

Vertikal oberhalb des Reaktorgehäuses 24 befinden sich insgesamt vier Pyrolysekammern 2, die in vertikaler Richtung von oben nach unten durchströmt werden. Jede Pyrolysekammer 2 ist von einem Heizmantel 16 umgeben, welcher die für die Pyrolyse erforderliche Prozesswärme liefert.

Oberhalb der insgesamt vier Pyrolysekammern 2 befinden sich einer jeweiligen Pyrolysekammer 2 zugeordnete Verdampfer 1, die ebenfalls mit durchmessergroßen Rohrleitungen 13 mit der Pyrolysekammer 2 verbunden sind. Die Rohrleitungen 13 besitzen jeweils Ventile 14. In der zur Pumpe 22 führenden Rohrleitung 26 befindet sich ein nicht dargestelltes Regelventil, mit welchem der Druck in der Prozesskammer 8 geregelt werden kann. Hierzu befindet sich im Inneren des Reaktorgehäuses 24 ein nicht dargestellter Drucksensor.

Mit der Bezugsziffer 23 sind Tore angedeutet, die geöffnet werden können, um die Prozesskammer mit Substraten zu be- / entladen bzw. um Masken 20 in die Prozesskammer einzubringen.

In dem Verdampfer 1 befinden sich in der Figur 4 gestrichelt angedeutete Schalen, in denen der Ausgangsstoff bei einer Verdampfungstemperatur von etwa 110°C gelagert wird. Durch den Verdampfer 1 fließt ein vom MFC 10 kontrollierter Trägergasstrom von etwa 500 sccm. In der Pyrolysezelle 2 wird das vom Trägergas transportierte Dimer pyrolytisch zerlegt. Die Strömungsgeschwindigkeit ist mit Hilfe der Pumpe 22 derart eingestellt, dass die Verweilzeit des Gases innerhalb der Pyrolysekammer 2 in der Größenordnung von Millisekunden, also etwa 0,5 bis 5 ms liegt. Die Pumpleistung und die Strömungswiderstände der Gesamtvorrichtung sind dabei so gewählt, dass innerhalb der Pyrolysekammern 2 ein Totaldruck von etwa 1 mbar herrscht.

Durch die insgesamt vier Gasleitungen 15 werden die Zerlegungsprodukte vom Trägergas in den Eingangsverteiler 9 geleitet, welcher in den Showerhead-Gaseinlass 3 mündet. Dort verteilt sich das Prozessgas gleichmäßig und tritt durch die Gasaustrittsöffnungen 6 in die Prozesskammer 8 ein.

Die Durchmesser der Gasaustrittsöffnungen 6 und deren Anzahl sind dabei derartig an den Strömungswiderstand der Gesamtanlage und die Pumpleistung der Pumpe 22 angepasst, dass dort ein derartiger Druckgradient auftritt, dass innerhalb der Prozesskammer 8 ein Prozessdruck von etwa 0,1 mbar herrscht. Der Druck in der Prozesskammer 8 ist somit etwa um den Faktor 10 geringer als der Druck in der Pyrolysekammer 2.

Mittels in der Figur 4 nicht dargestellten Heizmanschetten werden die Gasleitungen 15 und 9 sowie das Einlassorgan 3 auf einer Temperatur gehalten, die größer ist als die Polymerisations- bzw. Kondensationstemperatur der mit dem Trägergas transportierten Zerlegungsprodukte. Die Gasaustrittsfläche 3' des Gaseinlasses 3 kann mittels Heizdrähten beheizt werden. Die auf den Suszeptor 4 weisende Gasaustrittsfläche 3' ist goldbeschichtet und Hochglanz poliert.

Das in die Prozesskammer 8 eingetretene Prozessgas kondensiert auf der Oberfläche des vorstrukturierten Substrates 7. Letzteres liegt auf der Tragfläche 4' des Suszeptors 4 auf und wird von der Schattenmaske 20 derart überfangen, dass die Polymerisation nur an definierten Oberflächenabschnitten des Substrates 7 stattfindet.

Der Suszeptor 4 ist auf Polymerisationstemperatur gekühlt.

Bei dem in den Figuren 4 und 5 dargestellten Ausführungsbeispiel ist keine Kühlfalle vorgesehen. Nicht verbrauchtes Prozessgas kann an den Wandungen der durchmessergroßen Rohre 5, 26 kondensieren. Diese Rohre müssen von Zeit zu Zeit gereinigt werden.

Die Strukturen der Maske liegen im Bereich von 50 x 50 µm. Es werden Schichtdicken im Bereich zwischen 10 nm und 2 µm bei Wachstumsraten von etwa 100 nm/s abgeschieden.

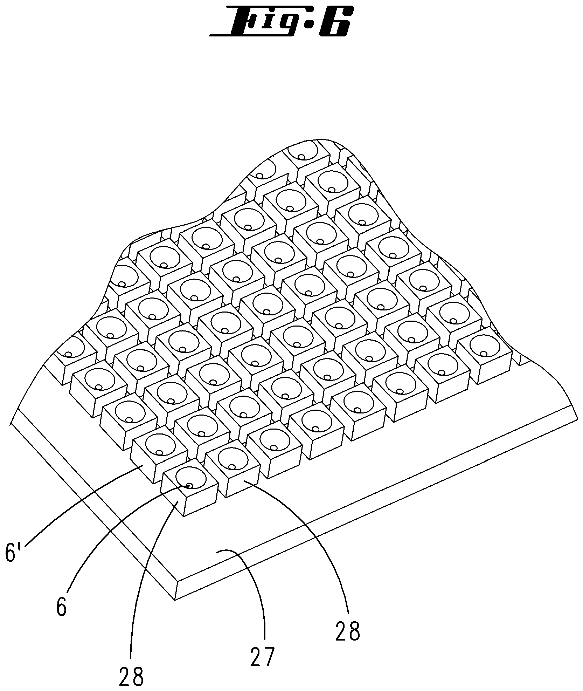

Die untere Wandung des Gaseinlasses 3, welche mit ihrer nach unten weisenden Oberfläche die Gasaustrittsfläche 3' ausbildet, besteht bevorzugt aus zwei Platten. Eine Innenplatte 27, die in Figur 6 ausschnittsweise und auf dem Kopf stehend dargestellt ist, besitzt eine Vielzahl von Bohrungen 6, die in Austrittskegelflächen 6' münden. Die Austrittskegelflächen 6' befinden sich in Vorsprüngen 28 mit einer quadratischen Grundfläche. Diese Vorsprünge 28 ragen nach unten und in quadratische Ausnehmungen 29 einer unteren Platte 30 hinein. Die obere Wandung der unteren Platte 30 besitzt Nuten, in denen sich Heizwendel 19 befinden. Die Nuten verlaufen im Bereich zwischen den Öffnungen 29. Im zusammengebauten Zustand verlaufen die Heizwendel 19 somit im Zwischenbereich zwischen den Vorsprüngen 28.

## Patentansprüche

1. Vorrichtung zum Abscheiden einer oder mehrerer dünner Schichten aus polymeren Para-Xylylene oder substituiertem Para-Xylylene mit einem beheizten Verdampfer (1) zum Verdampfen eines festen oder flüssigen Ausgangsstoffs, insbesondere in Form einen Polymers, insbesondere eines Dimers, in welchem Verdampfer (1) eine Trägergaszuleitung (11) für ein Trägergas mündet, mit welchem Trägergas der verdampfte Ausgangsstoff insbesondere das verdampfte Polymer, insbesondere Dimer in eine dem Verdampfer (1) nachgeordnete, beheizbare Zerlegungskammer (2), insbesondere Pyrolysekammer transportiert wird, in welcher der Ausgangsstoff, insbesondere in ein Monomer zerlegt wird, und mit einer der Zerlegungskammer (2) nachgeordneten Depositionskammer (8), welche einen Gaseinlass (3), durch welchen das vom Trägergas transportierte Zerlegungsprodukt, insbesondere Monomer eintritt, einen Suszeptor (4), welcher eine dem Gaseinlass (3) gegenüberliegende kühlbare Tragfläche (4') aufweist zur Auflage eines mit dem polymerisierten Zerlegungsprodukt, insbesondere Monomer zu beschichtenden Substrates (7), und einen Gasauslass (5), durch welchen das Trägergas und ein nicht polymerisierter Teil des Zerlegungsproduktes, insbesondere Monomers austritt, aufweist, wobei der Gaseinlass einen Gasflächenverteiler (3) ausbildet, der eine sich parallel zur Tragfläche (4') erstreckende, beheizbare Gasaustrittsfläche (3') aufweist, mit einer Vielzahl von über die gesamte Gasaustrittsfläche (3') verteilt angeordneten Gasaustrittsöffnungen (6), **dadurch gekennzeichnet, dass** die aktiv beheizbare Gasaustrittsfläche (3') hochglänzend ist und eine Emissivität ε < 0,04 aufweist.

2. Vorrichtung nach Anspruch 1, **dadurch gekennzeichnet, dass** der Gasflächenverteiler aus hochglanzpoliertem Metall, insbesondere goldbeschichteten Metall, insbesondere Aluminium oder Edelstahl besteht.

3. Vorrichtung nach einem der vorhergehenden Ansprüche, **dadurch gekennzeichnet, dass** der Gasflächenverteiler (3) eine Heizung aufweist, mit der er auf Temperaturen zwischen 150°C und 250°C aufheizbar ist und der Suszeptor (4) eine Temperiereinrichtung insbesondere Kühleinrichtung aufweist, mit der der Suszeptor (4) und insbesondere die Tragfläche (4') auf Temperaturen bis -30°C gekühlt und/ oder bis 100°C aufgeheizt werden kann.

4. Vorrichtung nach einem der vorhergehenden Ansprüche, **dadurch gekennzeichnet, dass** der Suszeptor (4) als Kühlblock ausgebildet ist mit Flüssigkeitsdurchtrittskanälen (18), durch welchen ein Temperiermittel strömt, welches in einem Temperaturbereich zwischen -30°C und 100°C flüssig ist und/ oder die Gasaustrittsfläche (3') ausbildende Platte des Gasflächenverteilers (3) Kanäle (19) aufweist, durch die ein Temperiermedium fließt, welches in einem Temperaturbereich zwischen 150°C und 250°C flüssig ist, oder einen elektrisch leitenden Leiter aufweist.

5. Vorrichtung nach einem der vorhergehenden Ansprüche, **dadurch gekennzeichnet, dass** der Abstand (A) zwischen der Tragfläche (4') und der Gasaustrittsfläche (3') im Bereich zwischen 10 mm und 50 mm beträgt.

6. Vorrichtung nach einem der vorhergehenden Ansprüche, **gekennzeichnet durch** eine den Gasauslass (5) nachgeordnete, druckgeregelte Vakuumpumpe, mit welcher ein Binnendruck in der Prozesskammer (8) zwischen 0,05 und 0,5 mbar einstellbar ist, insbesondere mit einer zwischen dem Gasauslass (5) und der Vakuumpumpe angeordneten Kühlfalle zum Ausfrieren des nicht polymerisierten Teiles des Monomers.

7. Vorrichtung nach einem der vorhergehenden Ansprüche, **dadurch gekennzeichnet, dass** die Verbindungsleitungen (13,15) zwischen Verdampfer (1), Pyrolysekammer (2) und Prozesskammer (8) sowie gegebenenfalls dort angeordnete Ventile (14) sowie eine sich an den Gasauslass (5) Gasausgangsleitung beheizbar sind.

8. Vorrichtung nach einem der vorhergehenden Ansprüche, **dadurch gekennzeichnet, dass** die Gasaustrittsfläche (3') im Wesentlichen der Tragfläche (4') entspricht bzw. jeweils den Rand des Substrates etwa um das Maß des Abstandes (A) zwischen Gasaustrittsfläche (3') und Tragfläche (4') überragt und insbesondere die Gasaustrittsfläche (3') bzw. die Tragfläche (4') größer als 0,5m² ist.

9. Vorrichtung nach einem der vorhergehenden Ansprüche, **dadurch gekennzeichnet, dass** mehrere, insbesondere vier Pyrolysekammern (2) mit jeweils einem zugeordneten Verdampfer (1) vertikal oberhalb des die Prozesskammer (8) ausbildenden Reaktorgehäuse (24) angeordnet sind.

10. Vorrichtung nach einem der vorhergehenden Ansprüche, **dadurch gekennzeichnet, dass** die Verdampfer (1) bzw. die Pyrolysekammern (2) in Vertil<alrichtung von oben nach unten durchströmt werden und insbesondere durch einen die Pyrolysekammer (2) umgebenden Heizmantel (16).

11. Vorrichtung nach einem der vorhergehenden Ansprüche, **dadurch gekennzeichnet, dass** die insbesondere durch den Rohrdurchmesser definierten Strömungswiderstände der Gasleitungen (13,15 und 23) und der im Wesentlichen durch die Durchmesser und die Anzahl der-Gasaustrittsöffnungen (6) definierte Strömungswiderstand des Gasflächenverteilers (3) so dimensioniert sind, dass bei einem Totaldruck von < 1 mbar in der Pyrolysekammer (2) und einem Totaldruck von etwa 0,1 mbar in der Prozesskammer (8) ein Totalgasfluss von mindestens 2.000 sccm erzielbar ist.

12. Verfahren zum Abscheiden ein oder mehrerer dünner Schichten aus polymerem Material, insbesondere Para-Xylylene, oder substituiertem Para-Xylylene wobei ein fester oder flüssiger, insbesondere von einem Polymer, insbesondere Dimer gebildeter Ausgangsstoff in einem Verdampfer (1) verdampft wird, der Ausgangsstoff, insbesondere das Dimer mittels eines Trägergases vom Verdampfer (1) durch eine Trägergaszuleitung (13) in eine Zerlegungskammer, insbesondere Pyrolysekammer (2) transportiert wird, in der Zerlegungskammer (2) bevorzugt pyrolytisch, insbesondere in ein Monomer zerlegt wird, das Zerlegungsprodukt, insbesondere Monomer vom Trägergas aus der Zerlegungskammer (2) in eine Depositionskammer (8) transportiert wird, in welcher ein Substrat (7) auf einer Tragfläche (4') eines Suszeptors (4) aufliegt, dort durch einen Gaseinlass (3) in die Depositionskammer (8) einströmt wobei das Zerlegungsprodukt, insbesondere Monomer zusammen mit dem Trägergas aus Gasaustrittsöffnungen (6) einer sich parallel zur Tragfläche (4') erstreckenden Gasaustrittsfläche (3) eines vom Gaseinlass (3) ausgebildeten Gasflächenverteilers in Richtung senkrecht auf die Substratoberfläche (7') austritt und auf der Oberfläche (7') des Substrates (7) als dünne Schicht polymerisiert, und wobei das Trägergas und ein nicht polymerisierter Teil des Zerlegungsproduktes, insbesondere Monomers aus einem Gasauslass (5) aus der Prozesskammer (8) austritt, wobei die Tragfläche (4') derart gekühlt und die der Tragfläche (4') gegenüberliegende Gasaustrittsfläche (3') derart beheizt wird, dass die Oberflächentemperatur der Gasaustrittsfläche (3') höher ist, als die Oberflächentemperatur der Tragfläche (4'), **dadurch gekennzeichnet, dass** Trägergas in Form dicht benachbarter "Gasstrahlen" aus den über die gesamte, hochglänzende und eine Emissivität ε < 0,04 aufweisende Gasaustrittsfläche (3') verteilt angeordneten Gasaustrittsöffnungen (6) austritt, die sich zu einem im Wesentlichen sich über die gesamte Tragfläche (4') erstreckenden vertikalen Volumengasstrom verbinden, wobei das Substrat in einer flächiger Wärmeleitverbindung auf der Tragfläche (4') aufliegt, über die von der aktiv beheizten Gasaustrittsfläche (3') auf das Substrat (7) übertragene Wärme in den Suszeptor (4) derart abgeleitet wird, dass die an zwei beliebigen Punkten auf der Oberfläche des Substrates (7) gemessene Temperaturen sich um maximal 10°C unterscheiden.

13. Verfahren nach Anspruch 12, **dadurch gekennzeichnet, dass** die Verdampfung des Ausgangsstoffes, insbesondere Dimers im Verdampfer (1) bei einer Temperatur zwischen 50°C und 200°C erfolgt und die Zerlegung des Ausgangsstoffes, insbesondere Dimers in das Zerlegungsprodukt, insbesondere Monomer in der Pyrolysekammer (8) bei Temperaturen zwischen 350°C und 700°C erfolgt und insbesondere in einem Druckbereich von < 1 mbar.

14. Verfahren nach einem der Ansprüche 12 bis 13, **dadurch gekennzeichnet, dass** der Flächenverteiler (3) auf einer Temperatur im Bereich von 150°C bis 250°C beheizt wird, die Wände (8') der Prozesskammer (8) auf eine Temperatur im Bereich von 150°C bis 250°C beheizt werden und der Suszeptor (4) auf eine Temperatur, die im Bereich zwischen -30°C und 100°C liegt, temperiert wird.

15. Verfahren nach einem der Ansprüche 12 bis 14, **dadurch gekennzeichnet, dass** der Totalgasfluss durch die Prozesskammer mindestens 2.000 sccm beträgt, wobei der Gaseinlass (3) von mehreren, insbesondere vier Pyrolysekammern (2) gespeist wird, durch welche jeweils ein gleicher Bruchteil des Gesamtgasflusses fließt.

## Claims

1. Apparatus for depositing one or more thin layers of polymeric para-xylylene or substituted para-xylylene, comprising a heated evaporator (1) for evaporating a solid or liquid starting material, in particular in the form of a polymer, in particular a dimer, into which evaporator (1) there extends a carrier-gas supply line (11) for a carrier gas, by which carrier gas the evaporated starting material, in particular the evaporated polymer, in particular dimer, is transported into a heatable decomposition chamber (2), in particular a pyrolysis chamber, which is located downstream of the evaporator (1) and in which the starting material is decomposed, in particular into a monomer, and comprising a deposition chamber (8), which is located downstream of the decomposition chamber (2) and has a gas inlet (3), through which the decomposition product, in particular monomer, transported by the carrier gas, enters, a susceptor (4), which has a coolable supporting surface (4') opposite the gas inlet (3) for supporting a substrate (7) that is to be coated with the polymerized decomposition product, in particular monomer, and a gas outlet (5), through which the carrier gas and an unpolymerized part of the decomposition product, in particular monomer, exits, the gas inlet forming a planar gas distributor (3), which has a heatable gas discharge surface (3') that extends parallel to the supporting surface (4') and has a multiplicity of gas discharge ports (6) distributed over the entire gas discharge surface (3'), **characterized in that** the actively heatable gas discharge surface (3') is highly reflective and has an emissivity of ε < 0.04.

2. Apparatus according to Claim 1, **characterized in that** the planar gas distributor consists of highly polished metal, especially gold-coated metal, in particular aluminum or high-grade steel.

3. Apparatus according to one of the preceding claims , **characterized in that** the planar gas distributor (3) has a heater, with which it can be heated up to temperatures between 150°C and 250°C and that the susceptor (4) has a temperature controlling device, in particular a cooling device, with which the susceptor (4), and in particular the supporting surface (4'), can be cooled to temperatures as low as -30°C and/or heated up to temperatures as high as 100°C.

4. Apparatus according to one of the preceding claims, **characterized in that** the susceptor (4) is formed as a cooling block with fluid passages (18), through which there flows a temperature control medium, which is liquid in a temperature range between -30°C and 100°C, and/or a plate of the planar gas distributor (3) that forms the gas discharge surface (3') has channels (19), through which there flows a temperature control medium, which is liquid in a temperature range between 150°C and 250°C, or has an electrically conducting conductor.

5. Apparatus according to one of the preceding claims, **characterized in that** the distance (A) between the supporting surface (4') and the gas discharge surface (3') is in the range between 10 mm and 50 mm.

6. Apparatus according to one of the preceding claims, **characterized by** a pressure-regulated vacuum pump, which is located downstream of the gas outlet (5) and with which an internal pressure in the process chamber (8) can be set between 0.05 and 0.5 mbar, in particular with a cooling trap disposed between the gas outlet (5) and the vacuum pump for freezing the unpolymerized part of the monomer.

7. Apparatus according to one of the preceding claims, **characterized in that** the connecting lines (13,15) between the evaporator (1), the pyrolysis chamber (2) and the process chamber (8) as well as valves (14) optionally disposed there and a gas outlet line connected to the gas outlet (5) are heatable.

8. Apparatus according to one of the preceding claims, **characterized in that** the gas discharge surface (3') substantially corresponds to the supporting surface (4') or protrudes beyond the edge of the substrate on each side approximately by the extent of the distance (A) between the gas discharge surface (3') and the supporting surface (4') and that the gas discharge surface (3') or the supporting surface (4') is larger than 0.5 m².

9. Apparatus according to one of the preceding claims, **characterized in that** a number of pyrolysis chambers (2), in particular four, each with an associated evaporator (1), are disposed vertically above the reactor housing (24) forming the process chamber (8).

10. Apparatus according to one of the preceding claims, **characterized in that** the evaporators (1) and the pyrolysis chambers (2) are flowed through in the vertical direction from top to bottom and particularly through a heating jacket (16) surrounding the pyrolysis chamber (2).

11. Apparatus according to Claim 1, **characterized in that** the flow resistances of the gas lines (13,15 and 9), defined in particular by the pipe diameter, and the flow resistance of the planar gas distributor (3), substantially defined by the diameters and the number of the gas discharge ports (6), are dimensioned such that, with a total pressure of < 1 mbar in the pyrolysis chamber (2) and a total pressure of approximately 0.1 mbar in the process chamber (8), a total gas flow of at least 2000 sccm can be achieved.

12. Method for depositing one or more thin layers of polymeric material, in particular para-xylylene, or substituted para-xylylene, a solid or liquid starting material, formed in particular by a polymer, in particular a dimer, being evaporated in an evaporator (1), the starting material, in particular the dimer, being transported by means of a carrier gas from the evaporator (1) through a carrier gas supply line (13) into a decomposition chamber, in particular a pyrolysis chamber (2), decomposed in the decomposition chamber (2), preferably pyrolytically, in particular into a monomer, the decomposition product, in particular monomer, being transported by the carrier gas from the decomposition chamber (2) into a deposition chamber (8), in which a substrate (7) rests on a supporting surface (4') of a susceptor (4), and flowing there through a gas inlet (3) into the deposition chamber (8), the decomposition product, in particular monomer, being discharged in a direction perpendicular to the substrate surface (7') together with the carrier gas from gas discharge ports (6) of a gas discharge surface (3'), extending parallel to the supporting surface (4'), of a planar gas distributor formed by the gas inlet (3) and polymerizing on the surface (7') of the substrate (7) as a thin layer, and the carrier gas and an unpolymerized part of the decomposition product, in particular monomer, exiting out of the process chamber (8) from a gas outlet (5), the supporting surface (4') being cooled and the gas discharge surface (3') that lies opposite the supporting surface (4') being heated in such a way that the surface temperature of the gas discharge surface (3') is higher than the surface temperature of the supporting surface (4'), **characterized in that** the carrier gas is discharged in the form of closely neighboring "gas jets" from the gas discharge ports (6), which are distributed over the entire gas discharge surface (3'), the gas discharge surface being highly reflective and having an emissivity of ε < 0.04, and combine to form a vertical volumetric gas flow extending substantially over the entire supporting surface (4'), the substrate resting on the supporting surface (4') in thermally conducting contact over the whole surface area, by way of which heat transferred from the actively heated gas discharge surface (3') to the substrate (7) is conducted away into the susceptor (4) in such a way that the temperatures measured at any two points on the surface of the substrate (7) differ by a maximum of 10°C.

13. Method according to Claim 12, **characterized in that** the evaporation of the starting material, in particular dimer, in the evaporator (1) takes place at a temperature between 50°C and 200°C and that the decomposition of the starting material, in particular dimer, into the decomposition product, in particular monomer, in the pyrolysis chamber (2) takes place at temperatures between 350°C and 700°C and, in particular, in a pressure range of < 1 mbar.

14. Method according to one of claims 12 to 13, **characterized in that** the planar distributor (3) is heated to a temperature in the range from 150°C to 250°C, that the walls (8') of the process chamber (8) are heated to a temperature in the range from 150°C to 250°C and that the susceptor (4) is controlled to a temperature which lies in the range between -30°C and 100°C.

15. Method according to one of claims 12 to 14, **characterized in that** the total gas flow through the process chamber is at least 2000 sccm, the gas inlet (3) being fed by a number of pyrolysis chambers (2), in particular four, through each of which there flows an equal fraction of the total gas flow.

## Revendications

1. Dispositif pour déposer une ou plusieurs couches minces de polymères de para-xylylène ou de para-xylylène substitué, comprenant un évaporateur chauffé (1) pour évaporer un matériau de départ solide ou liquide, en particulier sous la forme d'un polymère, en particulier d'un dimère, dans lequel évaporateur (1) débouche une ligne d'alimentation de gaz porteur (11) avec lequel le matériau de départ évaporé, en particulier le polymère évaporé, en particulier le dimère, est transporté dans une chambre de décomposition susceptible d'être chauffée (2), en particulier une chambre de pyrolyse, située en aval de l'évaporateur (1) et dans laquelle le matériau de départ est décomposé en particulier en un monomère, et comprenant une chambre de dépôt (8) située en aval de la chambre de décomposition (2) et comprenant une entrée de gaz (3) à travers laquelle entre le produit de décomposition, en particulier le monomère, qui est transporté par le gaz porteur, un suscepteur (4) comprenant une surface de support (4') pour supporter un substrat (7) à revêtir avec le produit de décomposition polymérisé, en particulier le monomère, laquelle est susceptible d'être refroidie et est située en face de l'entrée de gaz (3), et une sortie de gaz (5) à travers laquelle sort le gaz porteur et une partie non polymérisée du produit de décomposition, en particulier le monomère, dans lequel l'entrée de gaz forme un distributeur surfacique de gaz (3) présentant une surface de décharge de gaz (3') susceptible d'être chauffée laquelle s'étend parallèlement à la surface de support (4') et comporte une multiplicité d'orifices de décharge de gaz (6) répartis sur toute la surface de décharge de gaz (3'), **caractérisé en ce que** la surface de décharge de gaz (3') susceptible d'être chauffée activement est très réfléchissant et présente une émissivité de ε <0,04.

2. Dispositif selon la revendication 1, **caractérisé en ce que** le distributeur surfacique de gaz et fait d'un métal poli spéculaire, en particulier d'un métal revêtu d'or, en particulier de l'aluminium ou de l'acier inoxydable.

3. Dispositif selon l'une des revendications précédentes, **caractérisé en ce que** le distributeur surfacique de gaz (3) comporte un dispositif de chauffage avec lequel il peut être chauffé à des températures comprises entre 150°C et 250°C et **en ce que** le suscepteur (4) comporte un dispositif de régulation de température, en particulier un dispositif de refroidissement, avec lequel le suscepteur (4), et en particulier la surface de support (4'), peut être refroidi à des températures jusqu'à -30 ° C et/ou chauffé à des températures jusqu'à 100° C.

4. Dispositif selon l'une des revendications précédentes, **caractérisé en ce que** le suscepteur (4) est réalisé en tant que bloc de refroidissement avec des canaux de passage de fluide (18) à travers lesquels circule un moyen de régulation de température lequel est liquide dans une plage de température comprise entre -30°C et 100°C et/ou **en ce que** la plaque du distributeur surfacique de gaz (3) qui forme la surface de décharge de gaz (3'), présente des canaux (19) à travers lesquels circule un agent de régulation de température qui est liquide dans une plage de température entre 150°C et 250°C ou comporte un conducteur électriquement conducteur.

5. Dispositif selon l'une des revendications précédentes, **caractérisé en ce que** la distance (A) entre la surface de support (4') et la surface de décharge de gaz (3') est dans la plage comprise entre 10 mm et 50 mm.

6. Dispositif selon l'une des revendications précédentes, **caractérisé par** une pompe à vide à régulation de pression qui est située en aval de la sortie de gaz (5) et avec laquelle une pression interne dans la chambre de dépôt (8) est susceptible d'être réglée entre 0,05 et 0,5 mbar, en particulier avec un piège de refroidissement disposé entre la sortie de gaz (5) et la pompe à vide pour la congélation de la partie non polymérisée du monomère.

7. Dispositif selon l'une des revendications précédentes, **caractérisé en ce que** les conduites de liaison (13, 15) entre l'évaporateur (1), la chambre de pyrolyse (2) et la chambre de traitement (8), ainsi que des vannes (14) qui y sont agencées le cas échéant et une conduite de sortie de gaz raccordée à la sortie de gaz (5) sont susceptibles d'être chauffées.

8. Dispositif selon l'une des revendications précédentes, **caractérisé en ce que** la surface de décharge de gaz (3') correspond sensiblement à la surface de support (4') ou dépasse au-delà de chaque bord du substrat approximativement d'une distance égale à l'espacement (A) entre la surface de décharge de gaz (3') et la surface de support (4') et **en ce que**, en particulier, la surface de décharge de gaz (3'), respectivement la surface de support (4') est supérieure à 0,5 m².

9. Dispositif selon l'une des revendications précédentes, **caractérisé en ce que** plusieurs chambres de pyrolyse (2), en particulier quatre, ayant chacune un évaporateur associé (1), sont disposées verticalement au-dessus du boîtier de réacteur (24) formant la chambre de traitement (8) .

10. Dispositif selon l'une des revendications précédentes, **caractérisé en ce que** les évaporateurs (1), respectivement les chambres de pyrolyse (2) sont, dans la direction verticale, traversés du haut vers le bas et en particulier à travers une enveloppe chauffante (16) entourant la chambre de pyrolyse (2).

11. Dispositif selon l'une des revendications précédentes, **caractérisé en ce que** les résistances à l'écoulement des conduites de gaz (13, 15 et 9), définies en particulier par le diamètre de conduite, et la résistance à l'écoulement du distributeur surfacique de gaz (3) définie sensiblement par les diamètres et le nombre d'orifices de décharge de gaz (6), sont dimensionnées de manière à ce qu'est susceptible d'être atteint un débit de gaz total d'au moins 2000 sccm avec une pression totale <1 mbar dans la chambre de pyrolyse (2) et une pression totale d'environ 0,1 mbar dans la chambre de traitement (8) .

12. Procédé pour déposer une ou plusieurs couches minces de matériau polymérique, en particulier du para-xylylène ou du para-xylylène substitué, dans lequel un matériau de départ solide ou liquide, formé en particulier par un polymère, en particulier un dimère, est évaporé dans un évaporateur (1), le matériau de départ, en particulier le dimère, est transporté au moyen d'un gaz porteur depuis l'évaporateur (1) à travers une conduite d'alimentation de gaz porteur (13) dans une chambre de décomposition, en particulier une chambre de pyrolyse (2), est décomposé dans la chambre de décomposition (2), de préférence par pyrolyse, en particulier en un monomère, le produit de décomposition, en particulier le monomère, est transporté par le gaz porteur depuis la chambre de décomposition (2) dans une chambre de dépôt (8) dans laquelle un substrat (7) repose sur une surface de support (4') d'un suscepteur (4), en entrant dans la chambre de dépôt (8) à travers une entrée de gaz (3), le produit de décomposition, en particulier le monomère, étant déchargé ensemble avec le gaz porteur dans une direction perpendiculaire sur la surface du substrat (7') par des orifices de décharge de gaz (6) d'une surface de décharge de gaz (3') s'étendant parallèlement à la surface de support (4'), d'un distributeur surfacique de gaz formé par l'entrée de gaz (3) et polymérisant en couche mince sur la surface (7') du substrat (7), et le gaz porteur et une partie non polymérisée du produit de décomposition, en particulier le monomère, sortant de la chambre de traitement (8) par une sortie de gaz (5), la surface de support (4') étant refroidie et la surface de décharge de gaz (3') qui se trouve en face de la surface de support (4') étant chauffée de manière à ce que la température de surface de la surface de décharge de gaz (3') soit supérieure à la température de surface de la surface de support (4'), **caractérisé en ce que** du gaz porteur est déchargé sous la forme de « jets de gaz » étroitement voisins depuis les orifices de décharge de gaz (6) répartis sur toute la surface de décharge de gaz (3') qui est très réfléchissante et a une émissivité ε < 0,04, et se combinent pour former un flux de gaz volumétrique vertical s'étendant sensiblement sur toute la surface de support (4'), le substrat reposant sur la surface de support (4') en contact surfacique thermiquement conducteur, par l'intermédiaire de laquelle la chaleur transférée de la surface de décharge de gaz (3') activement chauffée au substrat (7) est conduite dans le suscepteur (4) de telle manière que les températures mesurées en deux points quelconques sur le substrat La surface du substrat (7) diffère au maximum de 10°C.

13. Procédé selon la revendication 12, **caractérisé en ce que** l'évaporation du matériau de départ, en particulier du dimère, a lieu dans l'évaporateur (1) à une température comprise entre 50°C et 200°C et **en ce que** la décomposition du matériau de départ, en particulier du dimère, en produit de décomposition, en particulier le monomère, a lieu dans la chambre de pyrolyse (2) à des températures comprises entre 350°C et 700°C et, en particulier, dans une plage de pression <1 mbar.

14. Procédé selon l'une des revendications 12 à 13, **caractérisé en ce que** le distributeur surfacique (3) est chauffé à une température dans la plage de 150°C à 250°C, **en ce que** les parois (8') de la chambre de traitement (8) sont chauffées à une température dans la plage comprise entre 150°C et 250°C et le suscepteur (4) est régulé à une température située dans une plage comprise entre -30°C et 100°C.

15. Procédé selon l'une des revendications 12 à 14, **caractérisé en ce qu'**un flux de gaz total à travers la chambre de traitement est d'au moins 2000 sccm, l'entrée de gaz (3) étant alimentée par une pluralité de chambres de pyrolyse (2), en particulier quatre, à travers chacune desquelles circule une fraction égale du débit total de gaz.
